# EUROPEAN PATENT SPECIFICATION

(11) **EP 2 509 139 B1**
(45) Date of publication and mention of the grant of the patent: **23.10.2013**
(21) Application number: 12002395.7
(22) Date of filing: 02.04.2012
(51) Int. Cl.: H01M 4/134, H01M 4/38, H01M 4/36, C23C 16/26, C23C 16/44, H01M 10/0525, H01M 4/62

(54) **Method for manufacturing negative electrode active material for use in non-aqueous electrolyte secondary battery, negative electrode material for use in non-aqueous electrolyte secondary battery and non-aqueous electrolyte secondary battery**
Verfahren zur Herstellung von Negativ-Elektrodenaktivmaterial zur Verwendung in einer nichtwässrigen Elektrolyt-Sekundärbatterie, Negativ-Elektrodenmaterial zur Verwendung in einer nichtwässrigen Elektrolyt-Sekundärbatterie und nichtwässrige Elektrolyt-Sekundärbatterie
Procédé de fabrication d'un matériau actif d'électrode négative pour une utilisation dans une batterie secondaire à électrolyte non aqueuse, matériau d'électrode négative pour une utilisation dans une batterie secondaire à électrolyte non aqueuse et batterie secondaire à électrolyte non aqueuse

(30) Priority: 08.04.2011 JP 2011086694
(43) Date of publication of application: 10.10.2012
(73) Proprietor: Shin-Etsu Chemical Co., Ltd., Tokyo (JP)
(72) Inventor: Nakanishi, Tetsuo, Annaka-shi Gunma-ken (JP); Ikeda, Tatsuhiko, Annaka-shi Gunma-ken (JP)
(74) Representative: Wibbelmann, Jobst

(56) References cited:
- EP-A1- 1 879 247
- US-A1- 2006 003 227
- US-A1- 2006 166 098
- US-A1- 2009 142 665
- LIU H P ET AL: "In situ growth of a carbon nanofiber/Si composite and its application in Li-ion storage", NEW CARBON MATERIALS,, vol. 24, no. 2, 1 June 2009 (2009-06-01), pages 124-130, XP026306173, ISSN: 1872-5805, DOI: 10.1016/S1872-5805(08)60042-6 [retrieved on 2009-06-01]

## Description

### BACKGROUND OF THE INVENTION

### Field of the Invention

The present invention relates to a method for manufacturing a negative electrode active material for use in a non-aqueous electrolyte secondary battery, such as a lithium ion secondary battery, and more particularly to a method for manufacturing a carbon-coated negative electrode active material for use in a non-aqueous electrolyte secondary battery. The present invention also relates to a negative electrode material for use in a non-aqueous electrolyte secondary battery and a non-aqueous electrolyte secondary battery using the negative electrode active material.

### Description of the Related Art

As portable electronic devices, communication devices and the like have been rapidly advanced in recent years, non-aqueous electrolyte secondary batteries having a high energy density are strongly desired from the aspects of cost, size and weight reductions. Conventionally, methods that are known to increase the capacity of this kind of non-aqueous electrolyte secondary battery include, for example, a method using an oxide of B, Ti, V, Mn, Co, Fe, Ni, Cr, Nb, and Mo, and complex oxides thereof as a negative electrode material (Patent Documents 1 and 2), a method of using M₁₀₀₋ₓSiₓ(x ≥ 50 at%, M = Ni, Fe, Co, Mn) that has been melted and rapidly cooled as a negative electrode material (Patent Document 3), a method of using silicon oxide for a negative electrode material (Patent Document 4), and a method of using Si₂N₂O, Ge₂N₂O, or Sn₂N₂O as a negative electrode material (Patent Document 5).

Silicon is the most promising material to achieve the size reduction and capacity enhancement of the battery since it exhibits an extraordinarily high theoretical capacity of 4,200 mAh/g as compared with the theoretical capacity 372 mAh/g of carbonaceous materials that are currently used in commercial batteries. Silicon is known to take various forms of different crystalline structure depending on the preparation method thereof. For example, Patent Document 6 discloses a lithium ion secondary battery using single crystal silicon as a support for a negative electrode active material. Patent Document 7 discloses a lithium ion secondary battery using a lithium alloy LiₓSi (0≤x≤5) with single crystal silicon, polycrystalline silicon or amorphous silicon, where particularly LiₓSi with amorphous silicon is preferable, and pulverized crystalline silicon coated with amorphous silicon obtained by plasma decomposition of monosilane is exemplified. In this disclosure, however, 30 parts of a silicon component and 55 parts of graphite as a conductive agent are used in the battery as described in Example, and the potential battery capacity of silicon cannot be fully taken advantage of.

For the purpose of giving electrical conductivity to a negative electrode material, there are a method of performing a mechanical alloying process on graphite and metal oxides such as silicon oxide, and then carbonizing them (Patent Document 8), a method of coating the surface of a Si particle with a carbon layer by the chemical vapor deposition method (Patent Document 9), and a method of coating the surface of a silicon oxide particle with a carbon layer by the chemical vapor deposition method (Patent Document 10 and Patent Document 30). These methods enable the electrical conductivity to be improved by providing the carbon layer on the particle surface. In these methods, however, large variations in the volume of a silicon negative electrode during charge and discharge, which has been a problem to be overcome, cannot be alleviated, and accompanying deterioration in current collection and cycle performance cannot be prevented.

Accordingly, in recent years, a method of restricting the utilization ratio of the silicon battery capacity to suppress the volume expansion (Patent Documents 9, 11 to 13). As a method of using the grain boundary of a polycrystalline particle as a buffer zone for suppressing the volume variations, there are also disclosed a method of rapidly cooling silicon melt with alumina added (Patent Document 14), a method of using a polycrystalline particle of an α- and β-FeSi₂ mixed phase polycrystal (Patent Document 15), and high temperature plastic working of a single crystal silicon ingot (Patent Document 16).

There is also discloses a method for alleviating the volume expansion by devising a laminated structure of a silicon active material. For example, there are disclosed a method of disposing two layers of a silicon negative electrode consisting (Patent Document 17), a method for suppressing collapse of particles by coating or capsulating them with an oxide and carbon or other metal (Patent Documents 18 to 24), and other methods. There is also discloses a method for suppressing cycle performance reduction due to the volume expansion by controlling a growth direction when silicon is vapor-phase grown on a current collector directly (Patent Document 25).

As described above, with the conventional method in which the cycle performance of the negative electrode material is improved by coating the silicon surface with an amorphous metal layer or carbon to give the electrical conductivity, a volume expansion rate of the cannot be suppressed at all, although the electronic conductivity is improved.

Silicon oxide is represented by SiOₓ wherein x is slightly greater than the theory of 1 due to an oxide coating. It is known that the signal of crystalline silicon is not observed in X-ray diffractometry analysis and silicon oxide has an amorphous structure. It is also known that performing heat treatment on silicon oxide causes disproportionation to Si and SiO₂ and crystalline silicon is thereby grown. Since silicon oxide has Si-O bonding in any states, battery capacity reduction is caused by generating lithium oxide in charge and discharge processes. Therefore, the battery capacity of silicon oxide is smaller than that of silicon, but greater than that of carbon by a factor of 5 to 6 per mass. Silicon oxide experiences a relatively less volume expansion and is thus thought to be easy to use as a negative electrode active material.

The problem of silicon oxide to be overcome prior to practical use is a significantly low initial efficiency. This may be overcome by making up the irreversible fraction of capacity or by restraining the irreversible capacity. For example, the method of making up the irreversible fraction of capacity by previously doping silicon oxide with Li metal has been reported to be effective. Silicon oxide may be doped with Li metal by attaching a lithium foil to the surface of negative electrode active material (Patent Document 26) or by vapor depositing Li on the surface of a negative electrode active material (Patent Document 27). As for the attachment of the lithium foil, a thin lithium foil that matches with the initial efficiency of a silicon oxide negative electrode is hardly available or prohibitively expensive if available. There is thus a problem in that the deposition of lithium vapor makes the manufacture process complex and is impractical.

Aside from lithium doping, it is also disclosed to enhance the initial efficiency by increasing a mass proportion of silicon. For example, there are a method of adding silicon particles to silicon oxide particles to reduce the mass proportion of silicon oxide (Patent Document 28), and a method of obtaining mixed solids of silicon and silicon oxide by generating and precipitating silicon vapor in the same stage as a production stage of silicon oxide (Patent Document 29). Silicon has both high initial efficiency and high battery capacity as compared with silicon oxide, but is an active material exhibiting a volume expansion rate as high as 400% upon charging. Even when silicon is added to a mixture of silicon oxide and carbonaceous material, the volume expansion rate of silicon oxide is not maintained, and eventually at least 20 mass % of carbonaceous material must be added in order to suppress the battery capacity at 1,000 mAh/g. The method of obtaining the mixed solids by simultaneously generating silicon and silicon oxide vapors suffers from a working problem in that a low vapor pressure of silicon requires a production process at a high temperature in excess of 2,000°C.

The silicon-based active materials in metal form and oxide form each have had their own problem caused in practical use.

### CITATION LIST

### PATENT LITERATURE

Patent document 1: Japanese Patent No. 3008228
Patent document 2: Japanese Patent No. 3242751
Patent document 3: Japanese Patent No. 3846661
Patent document 4: Japanese Patent No. 2997741
Patent document 5: Japanese Patent No. 3918311
Patent document 6: Japanese Patent No. 2964732
Patent document 7: Japanese Patent No. 3079343
Patent document 8: Japanese Unexamined Patent Publication (Kokai) No. 2000-243396
Patent document 9: Japanese Unexamined Patent Publication (Kokai) No.2000-215887
Patent document 10: Japanese Unexamined Patent Publication (Kokai) No. 2002-42806
Patent document 11: Japanese Unexamined Patent Publication (Kokai) No. 2000-173596
Patent document 12: Japanese Patent No.3291260
Patent document 13: Japanese Unexamined Patent Publication (Kokai) No. 2005-317309
Patent document 14: Japanese Unexamined Patent Publication (Kokai) No. 2003-109590
Patent document 15: Japanese Unexamined Patent Publication (Kokai) No. 2004-185991
Patent document 16: Japanese Unexamined Patent Publication (Kokai) No. 2004-303593
Patent document 17: Japanese Unexamined Patent Publication (Kokai) No. 2005-190902
Patent document 18: Japanese Unexamined Patent Publication (Kokai) No. 2005-235589
Patent document 19: Japanese Unexamined Patent Publication (Kokai) No. 2006-216374
Patent document 20: Japanese Unexamined Patent Publication (Kokai) No. 2006-236684
Patent document 21: Japanese Unexamined Patent Publication (Kokai) No. 2006-339092
Patent document 22: Japanese Patent No. 3622629
Patent document 23: Japanese Unexamined Patent Publication (Kokai) No. 2002-75351
Patent document 24: Japanese Patent No.3622631
Patent document 25: Japanese Unexamined Patent Publication (Kokai) No. 2006-338996
Patent document 26: Japanese Unexamined Patent Publication (Kokai) No. H11-086847
Patent document 27: Japanese Unexamined Patent Publication (Kokai) No.2007-122992
Patent document 28: Japanese Patent No. 3982230
Patent document 29: Japanese Unexamined Patent Publication (Kokai) No. 2007-290919
Patent document 30: US 2009/0142665 A1

### SUMMARY OF THE INVENTION

As described above, the silicon-based active materials in metal form and oxide form each have had their own problem caused in practical use. Accordingly, there has been a desire for an improved negative electrode active material in which the volume variations accompanying the occlusion and release of Li can be sufficiently suppressed, and the reduction in electrical conductivity due to atomization by particles being broken and due to separation of particles from the current collector can be alleviated. The desired negative electrode active material also has a cost advantage, and enables mass production and application to use where repetitive cycle performance is particularly important, such as mobile phones.

The present invention was accomplished in view of the aforementioned problems, and it is an object of the present invention to provide a method for manufacturing a negative electrode active material for use in a non-aqueous electrolyte secondary battery in which high battery capacity given by the silicon-based active material is maintained and the volume expansion and the break in the active material are suppressed during charge and discharge. It is also an object of the present invention to provide a negative electrode material for use in a non-aqueous electrolyte secondary battery and a non-aqueous electrolyte secondary battery using the negative electrode active material of the present invention.

In order to accomplish the above objects, the present invention provides a method for manufacturing a carbon-coated negative electrode active material for use in a non-aqueous electrolyte secondary battery, wherein the method comprises the features of claim 1.

The carbon coating by the catalytic CVD method can be performed at a low temperature to coat, with carbon, the negative electrode active raw material including at least one of silicon oxide powder and silicon powder. This enables a treatment for giving the electrical conductivity to be performed while increases in a silicon grain size are suppressed during the coating, and the volume variations can be thus suppressed during charge and discharge. In addition, carbon vapor deposition to the negative electrode active raw material improves the electrical conductivity of the negative electrode active material.

In the method, amorphous silicon oxide powder can be used as the silicon oxide powder.

When the amorphous silicon oxide powder is used as the silicon oxide powder, a negative electrode active material in which the volume variations are more suppressed during charge and discharge can be manufactured.

Moreover, polycrystalline silicon powder having a grain size of 300 nm or less can be used as the silicon powder. Here, the grain size is obtained by a Scherrer method based on a full width at half maximum of a diffraction line attributable to Si (111) and near 2θ = 28.4° in an x-ray diffraction pattern analysis of the silicon powder.

When the polycrystalline silicon powder having such a small grain size is used as the negative electrode active material, the volume variations can be more effectively suppressed during charge and discharge.

Moreover, the carbon coating by the catalytic CVD method can be performed by bringing a gas including an organic molecule having a carbon atom into contact with a heated catalyst to generate atomic carbon and by exposing the negative electrode active raw material to the generated atomic carbon.

The carbon coating by the catalytic CVD method is preferably performed with the temperature of the negative electrode active raw material held at less than 1,000°C.

In the present invention, the carbon coating of the negative electrode active material by the catalytic CVD method can be performed with the temperature of the negative electrode active raw material held at less than 1,000°C. This enables the increases in the silicon grain size to be more effectively suppressed during the coating.

Furthermore, the present invention provides a negative electrode material according to claim 8.

In the negative electrode material for use in a non-aqueous electrolyte secondary battery produced as above, its electrical conductivity is improved by the carbon vapor deposition on the negative electrode material. In addition to this, even when the expansion and contraction of the negative electrode active material due to charge and discharge are repeated, the negative electrode material can be prevented from being destroyed or atomized and the electrical conductivity of an electrode itself can be prevented from decreasing, since the treatment for giving the electrical conductivity with the carbon vapor deposition is performed so as to suppress the increases in the silicon grain size during the coating.

In this case, the negative electrode material preferably includes a polyimide resin as a binder.

By using the polyimide resin as the binder, even when the expansion and contraction of the negative electrode active material due to charge and discharge are repeated, the negative electrode material can be more effectively prevented from being destroyed or atomized.

Furthermore, the present invention provides a non-aqueous electrolyte secondary battery using the above-described negative electrode material.

The non-aqueous electrolyte secondary battery can be a lithium ion secondary battery.

When the above-described negative electrode material including the negative electrode active material is used for the non-aqueous electrolyte secondary battery, and particularly the lithium ion secondary battery, it exhibits high cycle performance and efficiency.

According to the method for manufacturing a carbon-coated negative electrode active material for use in a non-aqueous electrolyte secondary battery of the present invention, the negative electrode active raw material including at least one of silicon oxide powder and silicon powder can be coated with carbon at a low temperature. Therefore, the electrical conductivity of the negative electrode active material is improved by the carbon vapor deposition, and the treatment for giving the electrical conductivity can be performed while the increases in the silicon grain size are suppressed during the coating. As a result, the volume variations of the negative electrode material of the present invention can be suppressed during charge and discharge. The non-aqueous electrolyte secondary battery using the negative electrode material of the present invention has high cycle performance and efficiency in the charge and discharge repetition.

### BRIEF DESCRIPTION OF THE DRAWINGS

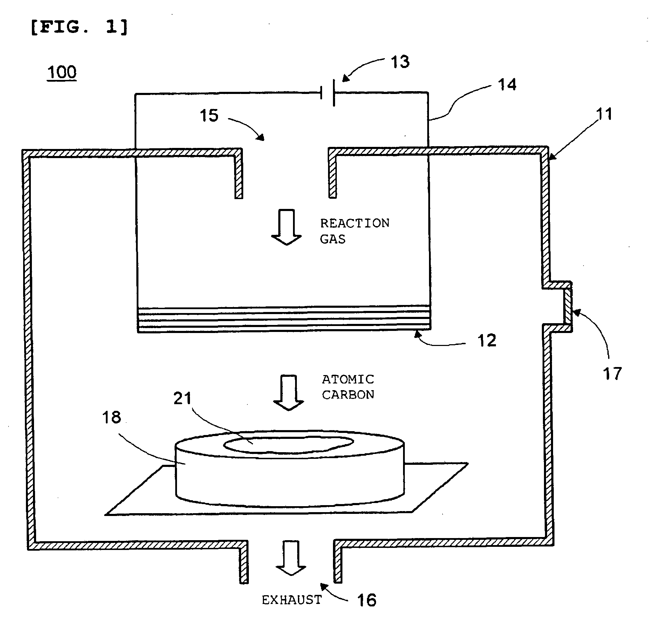

FIG. 1 is a schematic view showing an example of a catalytic CVD apparatus that can be used in the method for manufacturing a carbon-coated negative electrode active material for use in a non-aqueous electrolyte secondary battery of the present invention.

### DETAILED DESCRIPTION OF THE PREFERRED EMBODIMENTS

As described above, the silicon-based active material, which has higher battery capacity than a carbonaceous material has, has been studied. However, the silicon-based active materials in metal form and oxide form each have had their own problem caused in practical use. The battery expansion due to the electrode volume expansion and collapse of the silicon active material are the most important problem to realize the practical use of the silicon-based active material. There is thus a need to solve these problems.

The present invention discloses a method for coating, with carbon, at least one of silicon oxide powder and silicon powder, which are the silicon-based active material, and also discloses a method for manufacturing a negative electrode active material for use in a non-aqueous electrolyte secondary battery by the catalytic CVD method. In the manufacturing method, the carbon coating can be performed at a low temperature. The carbon coating by the catalytic CVD method enables the treatment for giving the electrical conductivity to be performed while the increases in the silicon grain size are suppressed. The volume variations due to the increases in the silicon grain size can be thus suppressed. By the carbon vapor deposition, the electrical conductivity of the negative electrode active material is improved, and even when the expansion and contraction of the negative electrode material due to charge and discharge are repeated, the negative electrode material can be prevented from being destroyed or atomized and the electrical conductivity of the electrode itself can be prevented from decreasing. When the negative electrode material is used for a non-aqueous electrolyte secondary battery, the non-aqueous electrolyte secondary battery can be obtained with good cycle performance. The present inventors made these findings, thereby bringing the present invention to completion.

The present invention will be described in more derail below.

In the present invention, the negative electrode active material including at least one of silicon oxide powder and silicon powder, which are the silicon-based active material, is coated with carbon by using the catalytic CVD method so that crystalline structure in which the silicon grain size is small can be obtained. This crystalline structure is effective to suppress the volume variations during charge and discharge.

In the present invention, a raw material for the negative electrode active material is silicon oxide. The term "silicon oxide" used herein generally refers to amorphous silicon oxides which are produced by heating a mixture of silicon dioxide and metallic silicon to produce a silicon oxide gas and cooling the resulting gas for precipitation. The silicon oxide is represented by the general formula SiOₓ wherein x is in the range of 0.5≤x<1.6. The mixture contains silicon dioxide and metallic silicon in a molar ratio of approximately 1:1. When the mixture is heated under reduced pressure at 1,300 to 1,500°C, the silicon oxide gas is produced. The gas is then introduced into a precipitating chamber at approximately 1,000 to 1,100°C, and silicon oxide is solidified and collected. Generally, silicon oxide in bulk form wherein x is in the range of 1.0≤x<1.2 is obtained in this way.

Well-known pulverizer and classifier are used to obtain a predetermined particle size of silicon oxide. Exemplary pulverizers used herein include a ball mill and media agitating mill in which grinding media such as balls and beads are brought in motion and an object is pulverized by utilizing impact forces, friction forces or compression forces generated by the kinetic energy; a roller mill in which pulverizing is performed by utilizing compression forces generated between rollers; a jet mill in which an object is impinged against the liner or each particle thereof is impinged at a high speed, and pulverizing is performed by impact forces generated by impingement; a hammer mill, pin mill and disc mill in which a rotor with hammers, blades or pins attached thereto is rotated and an object is pulverized by impact forces generated by rotation; a colloid mill utilizing shear forces; and a wet, high pressure, counter-impingement dispersing machine "Ultimizer". Either wet or dry pulverizing may be employed. The pulverizing is followed by dry, wet or sieve classifying in order to obtain a proper particle size distribution. The dry classifying generally uses a gas stream and includes successive or simultaneous processes of dispersion, separation (segregation between fine and coarse particles), collection (separation between solid and gas), and discharge. To prevent the classifying efficiency from being reduced by the impacts of interference between particles, particle shape, turbulence and velocity distribution of the gas stream, electrostatic charges, or the like, pretreatment (adjustment of water content, dispersibility, humidity or the like) is carried out prior to the classifying, or the gas stream is adjusted in moisture content and oxygen concentration prior to use.
An integrated type of dry pulverizer and classifier can conduct pulverizing and classifying operations at a time to obtain desired particle size distribution.

As is well known in the art, silicon to be used as the negative electrode active material is divided into single crystal silicon, polycrystalline silicon, and amorphous silicon in terms of crystallinity, and into chemical grade silicon, which is often referred to as metallic silicon, and metallurgical grade silicon in terms of purity. Particularly, in the present invention, polycrystalline silicon is preferably added as the negative electrode active raw material. The polycrystalline silicon consists of partially ordered crystals. On the other hand, amorphous silicon differs from polycrystalline silicon in that it assumes a substantially disordered arrangement of silicon atoms having a network structure, but may be used as the negative electrode active raw material of the present invention because amorphous silicon can be transformed into polycrystalline silicon by heat aging. Polycrystalline silicon is composed of differently-oriented crystal grains having a relatively large size, and has crystal grain boundaries between each of the crystal grains. As described in Complete Series of Inorganic Chemistry, Vol. XII-2, Silicon (Maruzen Co., Ltd.), p184, polycrystalline silicon can be synthesized from trichlorosilane or monosilane. The current mainstream processes for producing polycrystalline silicon in an industrial manner are the Siemens process and the Komatsu-ASiMI process involving pyrolysis of trichlorosilane or monosilane in a precipitating reactor (or bell jar) and depositing in silicon rod form. The Ethyl Corporation process involving using a fluidized bed reactor and growing polycrystalline silicon on surfaces of silicon particles is also available. Polycrystalline silicon may also be prepared by melting metallic silicon and segregating impurities by unidirectional solidification to increase the purity, or by quenching the silicon melt. It is known that the synthesized polycrystalline silicon differs in conductivity and residual strain depending on the size and orientation of crystal grains.

The polycrystalline silicon which is particularly useful in the present invention is one grown through pyrolysis with a silane gas, i.e., silane or chlorosilane, in a relatively low temperature range of particularly up to 1,000°C, and crystal growth. The production processes used herein include the Siemens process, the Komatsu-ASiMI process, and the Ethyl Corporation process. The Siemens process and the Komatsu-ASiMI process are batchwise in that polycrystalline silicon is precipitated on the surface of a silicon rod. In these batchwise processes, polycrystalline silicon growing on the rod surface undergoes recrystallization, relatively large crystal grains are likely to form.

On the other hand, the Ethyl Corporation process using a fluidized bed reactor is characterized by a high productivity, effective gas-solid heat transfer, and a uniform heat distribution within the reactor because polycrystalline silicon is grown on particle surfaces so that a large specific surface area is available for reaction. Since polycrystalline silicon particles growing to a particular particle size corresponding to the linear velocity of the fluidized bed are discharged from the interior of the reactor, continuous reaction is possible. Since the growth of grains is slow, relatively small crystal grains are formed.

Examples of the silane or chlorosilane used in the production processes described above include monosilane, disilane, monochlorosilane, dichlorosilane, trichlorosilane and tetrachlorosilane. The growth temperature of polycrystalline silicon on the rod is around 850°C when monosilane is used and around 1,100°C when trichlorosilane is used. Preference is given to monosilane and dichlorosilane which can be decomposed at a temperature of 1,000°C or less. Although the fluidized bed process using monosilane is performed at a further lower temperature of 600 to 800°C, the process is typically carried out around 650°C because operation at higher temperatures causes fine particles to form as a result of decomposition and growth in the vapor phase. The use of monosilane or dichlorosilane as reactant gas enables to maintain the reactor at a relatively low temperature, and the use of the fluidized bed reactor as the reaction system reduces the residence time within the fluidized bed and slows down the crystal growth of deposited polycrystalline silicon. As a result, fully densified crystal grains are formed, and fine voids are formed by grain deposition between crystal grains. It is thought that these fine voids function to alleviate the volume expansion and restrain the break during charging.

One effective physical measure for rating crystal grains of polycrystalline silicon is crystal grain measurement by X-ray diffraction. On X-ray diffraction pattern analysis, the grain size (the size of crystal grain) is obtained by the Scherrer method based on the full width at half maximum of a diffraction line attributed to Si(111) and near 2θ = 28.4°. In the method for manufacturing a carbon-coated negative electrode active material for use in a non-aqueous electrolyte secondary battery of the present invention, polycrystalline silicon powder in which the grain size obtained by the Scherrer method is 300 nm or less is preferably used as the negative electrode active raw material. A smaller grain size is particularly preferable. The grain size of the polycrystalline silicon produced from monosilane is approximately from 20 to 100 nm, and this size is particularly preferable to the present invention. The grain size of the polycrystalline silicon produced from trichlorosilane is approximately from 150 to 300 nm, and this size is observed to be larger than that of the polycrystalline silicon produced from monosilane. On the other hand, the grain size of metallic silicon and polycrystalline silicon produced by unidirectional solidification, quenching or high temperature plastic working method is from 500 to 700 nm, which are further larger than that.

The polycrystalline silicon produced in the fluidized bed reactor has a specific gravity of approximately 2.300 to 2.320, which is very low as compared with single crystal silicon and is assumed to have highly amorphous crystal structure. On the other hand, polycrystalline silicon produced with trichlorosilane by the Siemens process, polycrystalline silicon produced with monosilane by the Komatsu-ASiMI process, and metallic silicon have a specific gravity of 2.320 to 2.340, which is substantially equal to that of single crystal silicon and thus have a densified crystal structure within particles.

Since the polycrystalline silicon produced by the described-above process has chemically bonded hydrogen atoms, its silicon purity can be improved typically by heat treatment at 1,000 to 1,200°C for a brief time of 2 to 4 hours. The hydrogen content which is normally about 600 to 1,000 ppm prior to the heat treatment may be reduced to 30 ppm or less by the heat treatment. Polycrystalline silicon that has been purified to a hydrogen content of 30 ppm or less by the heat treatment is preferable for the negative electrode material.

The produced silicon oxide or polycrystalline silicon in bulk form is further pulverized prior to use. For the management of its particle size, the particle size distribution may be measured by the laser diffraction scattering method. A powder sample of particles having a total volume of 100% is analyzed to draw a cumulative curve, and the particle size at 10%, 50%, and 90% on the cumulative curve is designated 10% diameter, 50% diameter, and 90% diameter (in µm), respectively. In the invention, evaluation is made on the basis of a cumulative median diameter D₅₀ of 50% diameter (a median diameter). The median diameter D₅₀ of the negative electrode active raw material of the present invention is preferably not less than 0.1 µm and not more than 50 µm, and more preferably not less than 1 µm and not more than 20 µm. When D₅₀ is 0.1 µm or more, an excessively large specific surface area accompanied by an excessively small negative electrode film density can be prevented. When D₅₀ is 50 µm or less, short-circuits caused by the negative electrode active raw material penetrating the negative electrode film.

The resulting powdered particles pulverized in a predetermined size, which is a raw material for the negative electrode active material, is exposed to atomic carbon generated by bringing the gas including an organic molecule having a carbon atom into contact with a resistance-heated catalyst having a high melting point. This method is called as a hot wire CVD (HW-CVD) method, hot filament CVD (HF-CVD) method, or catalytic CVD (Cat-CVD) method. In a thermal CVD method, it is necessary to heat a vapor deposition base material, i.e., powder to be coated with carbon, and a reaction chamber to 1,000°C or more, and thereby the silicon grain size increases. On the other hand, the advantage of the catalytic CVD method is that the vapor deposition base material can be held at a room temperature or about room temperature. In the catalytic CVD method, therefore, the vapor deposition base material temperature does not need to be adjusted to the pyrolysis temperature of the organic molecule having a carbon atom and may be set to a desired temperature. The catalytic CVD method also has other advantages that it does not generate plasma damage of the vapor deposition base material, which is generally generated by a plasma CVD and the like, the apparatus structure is simple, and the decomposition efficiency of reaction gas is high.

An example of the catalytic CVD apparatus usable in the method for manufacturing a carbon-coated negative electrode active material for use in a non-aqueous electrolyte secondary battery of the present invention is shown in FIG. 1. The catalytic CVD apparatus 100 has a chamber 11 for reaction. A gas inlet 15 and gas outlet 16 are provided in the chamber 11. The catalytic CVD apparatus may include an observation window 17. A catalytic filament 12 is provided in the chamber 11. The catalytic CVD apparatus 100 also has a power source 13 and a conducting wire 14 for resistance heating of the filament 12. A tray 18 for holding the negative electrode active raw material 21 is provided in the chamber 11.

A reaction gas introduced from the gas inlet 15 comes into contact with the catalytic filament 12 to generate atomic carbon. The negative electrode active raw material 21 held on the tray 18 is exposed to the generated atomic carbon, and thereby coated with carbon.

The catalytic CVD method is performed under reduced pressure. The pressure is preferably reduced to approximately 100 to 5,000 Pa. When the pressure is reduced to 100 Pa or more, there is an economic advantage because the concentration of the reaction gas is sufficiently high and thereby the vapor deposition rate is high. When the pressure is reduced to 5,000 Pa or less, a vapor deposition film tends to be uniform, and the deterioration of the catalyst can be suppressed.

During the carbon coating process, the temperature of the negative electrode active raw material is preferably held at less than 1,000°C, and more preferably less than 700 °C. When the negative electrode active raw material is coated with carbon at less than 1,000°C, its silicon grain size is prevented from increasing, and the volume variations of the negative electrode produced by using this negative electrode active raw material can be sufficiently suppressed. Although the temperature of the negative electrode active raw material may be a room temperature as described above, a temperature of approximately not less than 200°C and less than 1000°C is preferable to enhance productivity and suppress the separation of the carbon coating. When the held temperature is 400°C or less, the silicon grain size hardly increases. The temperature of the negative electrode active raw material is preferably 400°C or less to suppress the increases in the grain size. From the view point of the above-described productivity, the temperature of the negative electrode active raw material is preferably not less than 400°C and less than 1000°C.

Exemplary high melting point catalysts used herein include metal such as ruthenium, tantalum, tungsten, rhenium, and indium, stainless steel (SUS304), alloys such as nickel chrome alloys, and carbon. The high melting point catalyst is resistance-heated to a melting point or less to be used as a catalyst. The melting point of rhenium, which has the lowest melting point among the above-described metal, is 2334°C. However, the catalyst temperature during the carbon coating process is preferably 1600°C or more, including other metal. The upper limit of the catalyst temperature is the melting point. When the catalyst temperature is 1600°C or more, the decomposition efficiency of the organic molecule is sufficient. The catalyst temperature during the carbon coating process is preferably 2000°C or less to suppress the deterioration of the catalyst.

The gas including an organic molecule having a carbon atom is selected from gases capable of producing atomic carbon by contact and decomposition, for example, hydrocarbons such as methane, ethane, propane, butane, pentane, hexane, etc., and ethylene, propylene, butylene, acetylene, etc., alone or in admixture, or alcohols such as methanol and ethanol, mono- to tri-cyclic aromatic hydrocarbons such as benzene, toluene, xylene, styrene, ethylbenzene, diphenylmethane, naphthalene, phenol, cresol, nitrobenzene, chlorobenzene, indene, coumarone, pyridine, anthracene, and phenanthrene, alone or in admixture. Also, gas light oil, creosote oil, anthracene oil, naphtha cracked tar oil, alone or in admixture, obtained from the tar distillation step are useful.

Typically, the organic molecule having a carbon atom also has a hydrogen atom. The organic molecule may have an oxygen atom, nitrogen atom, chlorine atom, and other atoms, like the above exemplary compounds. The gas including the organic molecule having a carbon atom may include a hydrogen molecule, nitrogen molecule, oxygen molecule, argon, carbon monoxide, nitrogen monoxide, etc., other than the above organic molecule having a carbon atom.

When the negative electrode is produced by using the negative electrode material with the above negative electrode active material, the binder is preferably selected from polyimide resins, and more preferably aromatic polyimide resins. The aromatic polyimide resins has good solvent resistance, and can suppress its separation from the current collector and the separation of the active material accompanying the volume expansion due to charge and discharge.

Aromatic polyimide resins are generally hardly-soluble in organic solvents and must not effect the swelling or be dissolved in electrolyte. In general, the aromatic polyimide resin is soluble only in high-boiling organic solvents, for example, cresol. An electrode paste may be prepared by adding polyimide precursors in a state of a polyamic acid that is relatively easily soluble in various organic solvents such as dimethylformamide, dimethylacetamide, N-methylpyrrolidone, ethyl acetate, acetone, methyl ethyl ketone, methyl isobutyl ketone, and dioxolan, and the paste is then subjected to heat treatment at a temperature of 300°C or more for a long time for thereby effecting dehydration and imidization. The binder is obtained in this way.

Suitable aromatic polyimide resins used herein has a basic skeleton derived from tetracarboxylic dianhydrides and diamines. Exemplary tetracarboxylic dianhydrides include aromatic tetracarboxylic dianhydrides such as pyromellitic dianhydride, benzophenonetetracarboxylic dianhydride and biphenyltetracarboxylic dianhydride, alicyclic tetracarboxylic dianhydrides such as cyclobutanetetracarboxylic dianhydride, cyclopentanetetracarboxylic dianhydride and cyclohexanetetracarboxylic dianhydride, and aliphatic tetracarboxylic dianhydrides such as butanetetracarboxylic dianhydride.

Exemplary diamines include aromatic, alicyclic and aliphatic diamines such as, p-phenylene diamine, m-phenylene diamine, 4,4'-diaminodiphenylmethane, 4,4'-diaminodiphenyl ether, 2,2'-diaminodiphenylpropane, 4,4'-diaminodiphenyl sulfone, 4,4'-diaminobenzophenone, 2,3-diaminonaphthalene, 1,3-bis(4-aminophenoxy)benzene, 1,4-bis(4-aminophenoxy)benzene, 4,4'-di(4-aminophenoxy)diphenyl sulfone, 2,2'-bis[4-(4-aminophenoxy)phenyl]propane.

Synthesis of polyamic acid intermediate is commonly carried out by a solution polymerization process. The process uses a solvent such as N,N'-dimethylformamide, N,N'-dimethylacetamide, N-methyl-2-pyrrolidone, N-methylcaprolactam, dimethyl sulfoxide, tetramethyl urea, pyridine, dimethyl sulfone, hexamethylphosphoramide, and butyrolactone, alone or in admixture. The reaction temperature is commonly in the range of -20 to 150°C, and desirably -5 to 100°C.

The polyamic acid intermediate is converted into a polyimide resin typically by heating to induce dehydration and cyclization. Heating for dehydration and cyclization may be performed at any temperature in the range of 140 to 400°C and preferably 150 to 250°C. The time taken for dehydration and cyclization is 30 seconds to 10 hours, and preferably 5 minutes to 5 hours, depending on the heating temperature.

As the polyimide resin, polyimide resin powder and N-methylpyrrolidone solution of polyimide precursors are commercially available. Examples include U-Varnish A, U-Varnish S, UIP-R and UIP-S (Ube Industries Ltd.), KAYAFLEX KPI-121 (Nippon Kayaku Co., Ltd.), and Rikacoat SN-20, PN-20 and EN-20 (New Japan Chemical Co., Ltd.)

The negative electrode material preferably contains 10 to 95 mass % of at least one of the silicon oxide powder and silicon powder coated with carbon according to the present invention. When it contains 10 mass % or more of the powder, the battery capacity can be improved effectively and sufficiently. When it contains 95 mass % or less of the powder, the binder does not run short, and the volume variations of the electrode can be readily suppressed. Particularly, the mass ratio is preferably 20 to 90 mass %, and more preferably, 50 to 90 mass %. The negative electrode active material preferably contains 1 to 20 mass % of the binder, and more preferably contains 3 to 15 mass % of the binder. Enough binder enables separation of the negative electrode active material to be suppressed. When an excessive amount of the binder is not contained but a proper amount of the binder is contained, the reduction of a void rate and the interference with Li ion movement accompanying an increasing thickness of an insulator film can be suppressed.

When the negative electrode material is produced by using the negative electrode active material manufactured according to the present invention, the conductive agent, such as graphite, can be added thereto. The type of conductive agent used herein is not restricted in particular as long as it is an electronically conductive material which does not cause decomposition or alteration in the battery to be manufactured. Specific conductive agents used herein include metals in powder or fiber form such as Al, Ti, Fe, Ni, Cu, Zn, Ag, Sn and Si, natural graphite, synthetic graphite, various coke powders, mesophase carbon, vapor phase grown carbon fibers, pitch base carbon fibers, PAN base carbon fibers, and graphite obtained by firing various resins. The conductive agent is preferably added in solvent dispersion form because an electrode paste in which the conductive agent is uniformly distributed and bonded to the polycrystalline silicon particle is obtained by previously dispersing the conductive agent in a solvent such as water or N-methyl-2-pyrrolidone and adding the dispersion. Any well-known surfactant may be used to disperse the conductive agent in the above solvent. The solvent used for the conductive agent is desirably the same as the solvent used for the binder.

The additive amount of the conductive agent is 50 mass % or less (i.e., the battery capacity per negative electrode material is approximately 1,000 mAH/g or more), preferably 1 to 30 mass %, and more preferably 1 to 10 mass %. Lack of the conductive agent may cause poor conductivity of the negative electrode material, and first resistance tends to be high, whereas increases in the conductive agent amount may cause decreases in the battery capacity.

Moreover, carboxymethyl cellulose, sodium polyacrylate, acrylic polymers or fatty acid esters may be added as a viscosity regulator to the negative electrode material together with the above-described polyimide resin binder.

The negative electrode material for use in a non-aqueous electrolyte secondary battery of the present invention may be shaped by the following method, for example. The above-described negative electrode active material, conductive agent, binder, and other additives are mixed in a solvent suitable for dissolution and dispersion of the binder such as water or N-methylpyrrolidone to form a paste-state mixture, and the mixture is then applied in a sheet form to the current collector. The current collector used herein has no restriction of the thickness thereof and surface treatment as long as it is made from currently used materials for the current collector of the negative electrode, such as a copper or nickel foil. The method of molding the mixture into a sheet is not restricted in particular, and any well-known method may be used.

The non-aqueous electrolyte secondary battery, and particularly the lithium ion secondary battery can be manufactured by using the negative electrode (the negative electrode in a shaped form) obtained as described above. The non-aqueous electrolyte secondary battery is characterized by using the above-described shaped negative electrode active material. Other materials of a positive material, separator, electrolyte, and non-aqueous electrolyte, and the battery shape, etc., are not restricted in particular, and well-known materials may be used.

Examples of the positive electrode active material include oxides, sulfides, and the like capable of occluding and releasing lithium ions, and they are used alone or in admixture. Specific materials include sulfides and oxides of metals excluding lithium such as TiS₂, MOS₂, NbS₂, ZrS₂, VS₂, V₂O₅, MoO₃, Mg(V₃O₈)₂, and lithium, and lithium-containing complex oxides. Composite metals such as NbSe₂ are also usable. For increasing the energy density, lithium complex oxides based on LipMetO₂ are desirable. Met is preferably at least one element of cobalt, nickel, iron and manganese and p has a value in the range: 0.05≤p≤1.10. Specific examples of the lithium complex oxides include LiCoO₂, LiNiO₂, LiFeO₂, and Li_{q}NiᵣCo₁₋ᵣO₂ (q and r have values varying with the charged and discharged state of the battery and usually in the range: 0<q<1 and 0.7<r≤1) having a layer structure, LiMn2O4 having a spinel structure, and rhombic LiMnO₂. Also used is a substitutional spinel type manganese compound adapted for high voltage operation, such as LiMetₛMn₁₋ₛO₄ (0<s<1), where Met is titanium, chromium, iron, cobalt, nickel, copper, zinc or the like.

The above-described lithium complex oxide is prepared, for example, by pulverizing and mixing a carbonate, nitrate, oxide or hydroxide of lithium and a carbonate, nitrate, oxide or hydroxide of a transition metal in accordance with the desired composition, and firing at a temperature in the range of 600 to 1,000°C under an oxygen atmosphere.

Organic materials may also be used as the positive electrode active material. Examples include polyacetylene, polypyrrole, poly-p-phenylene, polyaniline, polythiophene, polyacene, and polysulfide.

The positive electrode active material as above is mixed with the same conductive agent and binder as used for the negative electrode material, and they are applied to the current collector. A positive electrode may be shaped therefrom by a well-known method.

The separator disposed between the positive and negative electrodes is not particularly restricted as long as it is stable to the electrolytic solution and holds the solution effectively. General separators include a porous sheet or non-woven fabric of polyolefins, such as polyethylene and polypropylene, of copolymers thereof and of aramide resins. These sheets may be used as a single layer or a laminate of multiple layers. Ceramics such as metal oxides may be deposited on the surface of sheets. Porous glass and ceramics are used as well.

The solvent for a non-aqueous electrolyte secondary battery used in the present invention is not restricted in particular as long as it can serve for the non-aqueous electrolyte. General solvents include aprotic high-dielectric-constant solvents such as ethylene carbonate, propylene carbonate, butylene carbonate, and γ -butyrolactone; and aprotic low-viscosity solvents such as dimethyl carbonate, ethyl methyl carbonate, diethyl carbonate, methyl propyl carbonate, dipropyl carbonate, diethyl ether, tetrahydrofuran, 1,2-dimethoxyethane, 1,2-diethoxyethane, 1,3-dioxolan, sulfolane, methylsulfolane, acetonitrile, propionitrile, anisole, acetic acid esters, e.g., methyl acetate and propionic acid esters. It is desirable to use a mixture of an aprotic high-dielectric-constant solvent and an aprotic low-viscosity solvent in a proper ratio. It is also acceptable to use ionic liquids containing imidazolium, ammonium and pyridinium cations. The counter anions are not particularly restricted and include BF₄⁻, PF₆⁻ and (CF₃SO₂)₂N⁻. The ionic liquid may be used in admixture with the foregoing non-aqueous solvent.

In the case of using a solid electrolyte or gel electrolyte, a silicone gel, silicone polyether gel, acrylic gel, silicone acrylic gel, acrylonitrile gel, poly(vinylidene fluoride) or the like may be included in a polymer form. These ingredients may be polymerized prior to or after casting. They may be used alone or in admixture.

For example, light metal salts are used for the electrolyte salt. Examples of the light metal salts include salts of alkali metals such as lithium, sodium and potassium, salts of alkaline earth metals such as magnesium and calcium, and aluminum salts. A choice may be made among these salts or mixtures thereof depending on a particular purpose. Examples of suitable lithium salts include LiBF₄, LiClO₄, LiPF₆, LiAsF₆, CF₃SO₃Li, (CF₃SO₂)₂NLi, C₄F₉SO₃Li, CF₃CO₂Li, (CF₃CO₂)₂NLi, C₆F₅SO₃Li, C₈F₁₇SO₃Li, (C₂F₅SO₂)₂NLi, (C₄F₉SO₂) (CF₃SO₂)NLi, (FSO₂C₆F₄) (CF₃SO₂)NLi, ((CF₃)₂CHOSO₂)₂NLi, (CF₃SO₂)₃CLi, (3,5-(CF₃)₂C₆F₃)₄BLi, LiCF₃, LiAlCl₄, and C₄BO₈Li, which may be used alone or in admixture.

From the electric conductivity aspect, the concentration of the electrolyte salt in the non-aqueous electrolyte is preferably 0.5 to 2.0 mole/liter. The conductivity of the electrolyte is preferably 0.01 S/cm or more at a temperature of 25°C, which is adjusted according to the type and concentration of the electrolyte salt.

Moreover, various additives may be added to the non-aqueous electrolyte as needed. Examples include an additive for improving cycle life such as vinylene carbonate, methyl vinylene carbonate, ethyl vinylene carbonate and 4-vinylethylene carbonate, an additive for preventing over-charging such as biphenyl, alkylbiphenyl, cyclohexylbenzene, t-butylbenzene, diphenyl ether, and benzofuran, and various carbonate compounds, carboxylic acid anhydrides, nitrogen- and sulfur-containing compounds for acid removal and water removal purposes.

The secondary battery may take any desired shape and is not restricted in particular. In general, the battery is of the coin type in which electrodes and a separator, all punched into coin shape, are stacked, or of the rectangular or cylinder type in which electrode sheets and a separator are spirally wound.

### EXAMPLES

Hereinafter, the present invention will be described in more detail by showing preparation instances of the silicon oxide powder and silicon powder, Examples and Comparative Examples. However, the present invention is not restricted to Examples below. In Examples, "%" represent "mass %", and "a particle size" means a median diameter D₅₀ measured by a particle size distribution instrument utilizing by laser diffractometry. The grain size (the size of a crystal grain) is obtained by the Scherrer method based on the full width at half maximum of a diffraction line attributable to Si (111) and near 2θ = 28.4° in an x-ray diffraction pattern analysis.

### <Preparation of Silicon Oxide Powder 1>

A mixture of equimolar amounts of silicon dioxide powder (BET specific surface area = 200 m²/g) and chemical grade metallic silicon powder (BET specific surface area = 4 m²/g) was heated in a high-temperature and reduced-pressure atmosphere at 1,350°C and 100 Pa to produce SiO vapor. The produced SiO vapor was precipitated on a stainless steel (SUS) substrate held at 1,000°C. The precipitate was then recovered and crushed by a jaw crusher. The crushed material was pulverized in a jet mill (AFG-100 made by Hosokawa Micron Corp.) with the built-in classifier operating at 9,000 rpm. From a downstream cyclone, silicon oxide powder (SiOₓ: x=1.02) having D₅₀ = 7.6 µm and D₉₀ = 11.9 µm was recovered.

### <Preparation of Silicon Oxide Powder 2>

The silicon oxide powder 1 was maintained for 3 hours under argon stream in a furnace held at 1,000°C to cause disproportionation reaction.

### <Preparation of Polycrystalline Silicon Powder 1>

By introducing polycrystalline silicon particles into a fluidized bed at an internal temperature of 820°C and feeding monosilane thereto, particulate polycrystalline silicon was prepared. The prepared polycrystalline silicon was pulverized in the jet mill AFG-100 with the built-in classifier operating at 7,200 rpm and then classified through a classifier (TC-15 made by NISSHIN ENGINEERING INC.). The polycrystalline silicon powder having D₅₀ = 6.0 µm was thereby obtained.

### <Preparation of Polycrystalline Silicon Powder 2>

By introducing polycrystalline silicon chips heated to 1,100°C into a bell jar at an internal temperature of 400°C and feeding trichlorosilane thereto, a polycrystalline silicon mass was prepared. The prepared polycrystalline silicon mass was crushed by a jaw crusher, pulverized in the jet mill AFG-100 with the built-in classifier operating at 7,200 rpm, further pulverized in a bead mill for 4 hours, and classified through the classifier TC-15. The polycrystalline silicon powder having D₅₀ = 6.5 µm was thereby obtained.

### <Measurement of Grain Size of Negative Electrode Active Raw Material Powder>

Each grain size of the silicon oxide powder 1, 2 and polycrystalline silicon powder 1, 2 was obtained by the Scherrer method. The obtained values are shown in Table 1 below.

### (Example 1)

With the catalytic CVD apparatus shown in FIG. 1, the silicon oxide powder 1 was coated with carbon as described below. The silicon oxide powder 1 was placed in the chamber 11 of the catalytic CVD apparatus 100 including a tungsten filament having a diameter of 1 mm as a catalyst. The carbon vapor deposition process was then performed in the chamber at an internal pressure of 1,000 Pa with a reaction gas of methane/hydrogen/argon = 540/60/400 sccm. The temperature of the tray 18 was 500°C, and the reaction time was 10 hours.

### (Examples 2, 3 and 4)

The silicon oxide powder 2 (Example 2), polycrystalline silicon powder 1 (Example 3), and polycrystalline silicon powder 2 (Example 4) were each coated with carbon, as with the case of the silicon oxide powder 1 in Example 1.

### (Comparative Example 1)

The silicon oxide powder 1 was placed in a thermal CVD apparatus held at 1,100°C. A carbon vapor deposition process was then performed in a chamber at an internal pressure of 1,000 Pa with a reaction gas of methane/argon = 500/500 sccm. The temperature of a tray was 1,100°C, and the reaction time was 10 hours.

### (Comparative Examples 2 and 3)

The carbon vapor deposition process was performed on the polycrystalline silicon powder 1 and polycrystalline silicon powder 2, as with Comparative Example 1.

### <Measurement of Grain Size and Carbon Amount In Example 1 to 4 and Comparative Example 1 to 3>

Each grain size of the resulting reactants in Examples 1 to 4 and Comparative Examples 1 to 3 was obtained by the Scherrer method. Each carbon amount contained in the reactants was also measured. These values are shown in Table 1 below.

Table 1 shows the results of the grain size, average particle size (D₅₀), and carbon amount of the silicon oxide powder 1, 2, polycrystalline silicon powder 1, 2, and the powder obtained in Examples 1 to 4 and Comparative Examples 1 to 3.

**(Table 1)**

| | NEGATIVE ELECTRODE ACTIVE RAW MATERIAL POWDER | GRAIN SIZE (nm) | D₅₀ (µm) | CARBON (mass %) |
|---|---|---|---|---|
| | SILICON OXIDE POWDER 1 | NOT DETECTED | 7.6 | - |
| | SILICON OXIDE POWDER 2 | 6 | 7.6 | - |
| | POLYCRYSTALLINE SILICON POWDER 1 | 44 | 6.0 | - |
| | POLYCRYSTALLINE SILICON POWDER 2 | 149 | 6.5 | - |
| EXAMPLE 1 | SILICON OXIDE POWDER 1 | NOT DETECTED | 7.6 | 0.81 |
| EXAMPLE 2 | SILICON OXIDE POWDER 2 | 7 | 7.6 | 0.82 |
| EXAMPLE 3 | POLYCRYSTALLINE SILICON POWDER 1 | 44 | 6.0 | 1.2 |
| EXAMPLE 4 | POLYCRYSTALLINE SILICON POWDER 2 | 150 | 6.5 | 0.9 |
| COMPARATIVE EXAMPLE 1 | SILICON OXIDE POWDER 1 | 25 | 7.7 | 1.4 |
| COMPARATIVE EXAMPLE 2 | POLYCRYSTALLINE SILICON POWDER 1 | 160 | 6.0 | 1.8 |
| COMPARATIVE EXAMPLE 3 | POLYCRYSTALLINE SILICON POWDER 2 | 220 | 6.5 | 1.5 |

In Examples 1 and 2 in which the silicon oxide powder 1, 2 were coated with carbon by the catalytic CVD method, the carbon coating was accomplished without increasing the grain size. In Examples 3 and 4 in which the polycrystalline silicon powder 1, 2 were coated with carbon by the catalytic CVD method, also, the grain size increase was not observed.

On the other hand, in Comparative Examples 1 to 3 in which the carbon coating process was performed by the thermal CVD method, the grain size increased, and thus the grain size increase due to heating was observed. Despite the same tray temperature, the grain size of the powder obtained by heating the silicon oxide powder 1 in Comparative Example 1 was smaller than that of the polycrystalline silicon powder 1. It is understood that the oxide around the crystalline silicon suppressed to increase the grain size.

### (Examples 5 to 9, and Comparative Examples 4 to 6)

To confirm the effectiveness of the negative electrode material of the present invention in which the carbon-coated silicon oxide powder or silicon powder, the negative electrode materials were produced by using the negative electrode active materials manufactured in Examples 1 to 4 and Comparative Examples 1 to 3. Lithium secondary batteries for evaluation were then produced by using the negative electrode materials to measure charge-discharge capacity and a volume expansion ratio.

### <Production of Negative Electrode Material>

As the negative electrode active raw material, the silicon oxide powder obtained by coating the silicon oxide powder 1 with carbon in Example 1 was used in Examples 5 and 8, the silicon oxide powder obtained by coating the silicon oxide powder 2 with carbon in Example 2 was used in Example 6, the polycrystalline silicon powder obtained by coating the polycrystalline silicon powder 1 in Example 3 was used in Example 7, the polycrystalline silicon powder obtained by coating the polycrystalline silicon powder 2 in Example 4 was used in Example 9, the silicon oxide powder obtained by coating the silicon oxide powder 1 with carbon in Comparative Example 1 was used in Comparative Example 4, the polycrystalline silicon powder obtained by coating the polycrystalline silicon powder 1 in Comparative Example 2 was used in Comparative Example 5, and the polycrystalline silicon powder obtained by coating the polycrystalline silicon powder 2 in Comparative Example 3 was used in Comparative Example 6.

Except for Example 8, a mixture of silicon oxide powder or silicon powder, and a dispersion of acetylene black as the conductive agent in N-methylpyrrolidone (solids 17.5%) was diluted with N-methylpyrrolidone. A polyimide resin (solids 18.1%) as the binder was added thereto to form a slurry.

In Example 8, silicon oxide powder was diluted with N-methylpyrrolidone without adding acetylene black, and a polyimide resin (solids 18.1%) as the binder was added thereto to form a slurry.

These slurries were each coated onto a copper foil of 10 µm thick by means of a doctor blade having a gap of 75 µm, vacuum dried at 400°C for 2 hours, and pressed by a roller press at 60°C into an electrode shaped form. Finally, pieces of 2 cm² were punched out of the shaped form and used as the negative electrode material. The composition of solid components of the negative electrode materials manufactured as above is shown in Table 2.

### <Determination of Battery Properties>

Six lithium ion secondary batteries for evaluation (test cells) were produced each by using the negative electrode material obtained in Examples and Comparative Examples, a lithium foil as a counter electrode, the non-aqueous electrolyte solution obtained by dissolving lithium bis(trifluoromethanesulfonyl)imide in a 1/1 (by volume) mixture of ethylene carbonate and diethyl carbonate at a concentration of 1 mol/liter as the non-aqueous electrolyte, and a polyethylene microporous film having a thickness of 30 µm as the separator.

The manufactured test cells were aged overnight at room temperature. Two of the test cells were then disassembled, and its thickness was measured to calculate a film thickness on the basis of initial weight in a state swollen with electrolyte. Incidentally, it was calculated without including an increase amount of lithium due to charge and of the electrolyte. With a secondary battery charge/discharge tester (Nagano K.K.), other two of the test cells were charged with a constant current of 0.05 c until the voltage of the test cells reached 5 V, and after reaching 5 mV, the test cells were charged at a reduced current so that the cell voltage was maintained at 5 mV. When the current value had decreased below 0.02 c, the charging was terminated. Incidentally, "c" means a current value with which the theoretical capacity of a negative electrode is charged in 1 hour, and 1c equals 15 mA. After the charging, the test cells were disassembled, and the volume expansion ratio was calculated by measuring the thickness. Other two of the test cells were charged by the above-described method, and then discharged with a constant current of 0.05 c until the voltage of the test cells reached 1500 mV to calculate the charge-discharge capacity and first charge and discharge efficiency. These results are shown in Table 2 together with the composition of solid components of the negative electrode material. The charge-discharge capacity is capacity per active material except for the binder. The first charge and discharge efficiency is the proportion of discharge capacity to charge capacity expressed in percentage.

**(Table 2)**

| | EXAMPLE 5 | EXAMPLE 6 | EXAMPLE 7 | EXAMPLE 8 | EXAMPLE 9 | COMPARATIVE EXAMPLE 4 | COMPARATIVE EXAMPLE 5 | COMPARATIVE EXAMPLE 6 |
|---|---|---|---|---|---|---|---|---|
| EXAMPLE 1 SILICON OXIDE POWDER (mass %) | 85 | | | 90 | | | | |
| EXAMPLE 2 SILICON OXIDE POWDER (mass %) | | 85 | | | | | | |
| EXAMPLE 3 POLYCRYSTALLINE SILICON POWDER (mass %) | | | 85 | | | | | |
| EXAMPLE 4 POLYCRYSTALLINE SILICON POWDER (mass %) | | | | | 85 | | | |
| COMPARATIVE EXAMPLE 1 SILICON OXIDE POWDER (mass %) | | | | | | 85 | | |
| COMPARATIVE EXAMPLE 2 POLYCRYSTALLINE SILICON POWDER (mass %) | | | | | | | 85 | |
| COMPARATIVE EXAMPLE 3 POLYCRYSTALLINE SILICON POWDER (mass %) | | | | | | | | 85 |
| ACETYLENE BLACK (mass %) | 5 | 5 | 5 | 0 | 5 | 5 | 5 | 5 |
| POLYIMIDE RESIN (mass %) | 10 | 10 | 10 | 10 | 10 | 10 | 10 | 10 |
| VOLUME EXPANSION RATIO | 1.34 | 1.42 | 2.01 | 1.38 | 2.95 | 1.65 | 3.15 | 3.82 |
| CHARGE CAPACITY (mAh/g) | 2102 | 2074 | 3280 | 2220 | 3250 | 2088 | 3420 | 3320 |
| DISCHARGE CAPACITY (mAh/g) | 1501 | 1504 | 2936 | 1558 | 2900 | 1518 | 3005 | 2991 |
| FIRST CHARGE AND DISCHARGE EFFICIENCY (%) | 71.4 | 72.5 | 89.5 | 70.2 | 89.2 | 72.7 | 87.9 | 90.1 |

In Examples 5, 6, and 8 in which the silicon oxide powder of the present invention was used, the battery capacity hardly changed, and the volume expansion ratio was lower as compared with Comparative Example 4. In Examples 7 and 9 in which the silicon powder of the present invention was used, the volume expansion ratio was remarkably lower as compared with Comparative Examples 5 and 6. It was thus confirmed that the volume expansion, which has been a problem in practical use, can be suppressed with the negative electrode active material of the present invention.

### <Cycle Performance Evaluation>

A single layer sheet (trade name: Pioxcel C-100 made by Pionics Co., Ltd.) in which LiCoO₂ was used as the active material and an aluminum foil was used as the current collector was used as the positive electrode material to evaluate the cycle performance of the obtained negative electrode material (the negative electrode in a shaped form). Coin-type lithium ion secondary battery was produced by using a non-aqueous electrolyte solution obtained by dissolving lithium hexafluorophosphate in a 1/1 (by volume) mixture of ethylene carbonate and diethyl carbonate at a concentration of 1 mol/liter as the non-aqueous electrolyte and a polyethylene microporous film having a thickness of 30 µm as the separator.

The manufactured coin-type lithium ion secondary battery was aged two nights at room temperature. With a secondary battery charge/discharge tester (Nagano K.K.), the lithium ion secondary battery was then charged with a constant current of 1.2 mA (0.25 c on the basis of the positive electrode) until the voltage of the test cell reached 4.2 V, and after reaching 4.2 V, the battery was charged at a reduced current so that the cell voltage was maintained at 4.2 V. When the current value had decreased below 0.3 mA, the charging was terminated. The battery was discharged at a constant current of 0.6 mA, and the discharging was terminated when the cell voltage reached 2.5 V, and the discharge capacity was obtained. This operation was repeated 50 cycles. The discharge capacity every additional 10 cycles divided by the discharge capacity at the first cycle reported as a percent discharge capacity retentivity in Table 3. Example 6 showed less deterioration at the first cycle as compared with Comparative Example 4, and stable charge-discharge performance until 50 cycles.

**(Table 3)**

| CYCLE | PERCENT DISCHARGE CAPACITY RETENTIVITY (%) | |
|---|---|---|
| | EXAMPLE 7 | COMPARATIVE EXAMPLE 5 |
| 10 | 98 | 87 |
| 20 | 96 | 86 |
| 30 | 94 | 84 |
| 40 | 93 | 81 |
| 50 | 92 | 80 |

It is to be noted that the present invention is not restricted to the foregoing embodiment. The embodiment is just an exemplification, and any examples that have substantially the same feature and demonstrate the same functions and effects as those in the technical concept described in claims of the present invention are included in the technical scope of the present invention.

## Claims

1. A method for manufacturing a carbon-coated negative electrode active material for use in a non-aqueous electrolyte secondary battery, wherein a negative electrode active raw material including at least one of silicon oxide powder and silicon powder is coated with carbon by a catalytic CVD method, **characterised in that** the carbon coating by the catalytic CVD method is performed by bringing a gas including an organic molecule having a carbon atom into contact with a resistance-heated catalyst to generate atomic carbon and by exposing the negative electrode active raw material to the generated atomic carbon.

2. The method for manufacturing a carbon-coated negative electrode active material for use in a non-aqueous electrolyte secondary battery according to claim 1, wherein the resistance-heated catalyst includes metal such as ruthenium, tantalum, tungsten, rhenium, and indium, stainless steel (SUS304), alloys such as nickel chrome alloys, and carbon.

3. The method for manufacturing a carbon-coated negative electrode active material for use in a non-aqueous electrolyte secondary battery according to claim 2, wherein the resistance-heated catalyst includes tungsten.

4. The method for manufacturing a carbon-coated negative electrode active material for use in a non-aqueous electrolyte secondary battery according to claims 1 to 3, wherein the resistance-heated catalyst is a catalytic filament.

5. The method for manufacturing a carbon-coated negative electrode active material for use in a non-aqueous electrolyte secondary battery according to claims 1-4, wherein amorphous silicon oxide powder is used as the silicon oxide powder.

6. The method for manufacturing a carbon-coated negative electrode active material for use in a non-aqueous electrolyte secondary battery according to claim 1 to claim 5, wherein polycrystalline silicon powder having a grain size of 300 nm or less is used as the silicon powder, the grain size being obtained by a Scherrer method based on a full width at half maximum of a diffraction line attributable to Si (111) and near 2θ = 28.4° in an x-ray diffraction pattern analysis of the silicon powder.

7. The method for manufacturing a carbon-coated negative electrode active material for use in a non-aqueous electrolyte secondary battery according to any one of claims 1 to 6, wherein the carbon coating by the catalytic CVD method is performed with the temperature of the negative electrode active raw material held at less than 1,000°C.

8. A negative electrode material for use in a non-aqueous electrolyte secondary battery, including the negative electrode active material manufactured by the method for manufacturing a negative electrode active material for use in a non-aqueous electrolyte secondary battery according to any one of claims 1 to 7.

9. The negative electrode material for use in a non-aqueous electrolyte secondary battery according to claim 8, wherein the negative electrode material includes a polyimide resin as a binder.

10. A non-aqueous electrolyte secondary battery using the negative electrode material according to claim 8 or claim 9.

11. The non-aqueous electrolyte secondary battery according to claim 10, wherein the non-aqueous electrolyte secondary battery is a lithium ion secondary battery.

## Patentansprüche

1. Verfahren zum Herstellen eines Kohlenstoff-beschichteten Negativ-Elektrodenaktivmaterials zur Verwendung in einer nicht-wässrigen Elektrolyt-Sekundärbatterie, wobei ein Negativ-Elektrodenaktivrohmaterial einschließlich mindestens einem aus Siliziumoxidpulver und Siliziumpulver mit Kohlenstoff durch ein katalytisches CVD-Verfahren beschichtet wird, **dadurch gekennzeichnet, dass** die Kohlenstoffbeschichtung durch das katalytische CVD-Verfahren durch Inkontaktbringen eines Gases einschließlich eines organischen Moleküls mit einem Kohlenstoffatom mit einem widerstandserwärmten Katalysator, um atomaren Kohlenstoff zu erzeugen, und durch Aussetzen des Negativ-Elektrodenaktivrohmaterials mit dem erzeugten atomaren Kohlenstoff durchgeführt wird.

2. Verfahren zum Herstellen eines Kohlenstoff-beschichteten Negativ-Elektrodenaktivmaterials zur Verwendung in einer nicht-wässrigen Elektrolyt-Sekundärbatterie nach Anspruch 1, wobei der widerstandserwärmte Katalysator Metall wie Ruthenium, Tantal, Wolfram, Rhenium und Indium, Edelstahl (SUS304), Legierungen wie Nickelchromlegierungen, und Kohlenstoff einschließt.

3. Verfahren zum Herstellen eines Kohlenstoff-beschichteten Negativ-Elektrodenaktivmaterials zur Verwendung in einer nicht-wässrigen Elektrolyt-Sekundärbatterie nach Anspruch 2, wobei der widerstandserwärmte Katalysator Wolfram einschließt.

4. Verfahren zum Herstellen eines Kohlenstoff-beschichteten Negativ-Elektrodenaktivmaterials zur Verwendung in einer nicht-wässrigen Elektrolyt-Sekundärbatterie nach Ansprüchen 1 bis 3, wobei der widerstandserwärmte Katalysator ein katalytisches Filament ist.

5. Verfahren zum Herstellen eines Kohlenstoff-beschichteten Negativ-Elektrodenaktivmaterials zur Verwendung in einer nicht-wässrigen Elektrolyt-Sekundärbatterie nach Ansprüchen 1 bis 4, wobei amorphes Siliziumoxidpulver als das Siliziumoxidpulver verwendet wird.

6. Verfahren zum Herstellen eines Kohlenstoff-beschichteten Negativ-Elektrodenaktivmaterials zur Verwendung in einer nicht-wässrigen Elektrolyt-Sekundärbatterie nach Anspruch 1 bis Anspruch 5, wobei polykristallines Siliziumpulver mit einer Korngröße von 300 nm oder weniger als das Siliziumpulver verwendet wird, wobei die Korngröße durch ein Scherrer-Verfahren basierend auf der vollen Breite bei halbem Maximum einer Si-zurechenbaren Beugungslinie (111) und bei 2θ = 28,4° in einer Röntgenbeugungsmusteranalyse des Siliziumpulvers erhalten wird.

7. Verfahren zum Herstellen eines Kohlenstoff-beschichteten Negativ-Elektrodenaktivmaterials zur Verwendung in einer nicht-wässrigen Elektrolyt-Sekundärbatterie nach einem der Ansprüche 1 bis 6, wobei das Kohlenstoffbeschichten durch das katalytische CVD-Verfahren mit der bei weniger als 1000°C gehaltenen Temperatur des Negativ-Elektrodenaktivrohmaterials durchgeführt wird.

8. Negativ-Elektrodenmaterial zur Verwendung in einer nicht-wässrigen Elektrolyt-Sekundärbatterie, einschließend das durch das Verfahren zum Herstellen eines Negativ-Elektrodenaktivmaterials zur Verwendung in einer nicht-wässrigen Elektrolyt-Sekundärbatterie nach einem der Ansprüche 1 bis 7 hergestellte Negativ-Elektrodenaktivmaterial.

9. Negativ-Elektrodenmaterial zur Verwendung in einer nicht-wässrigen Elektrolyt-Sekundärbatterie nach Anspruch 8, wobei das Negativ-Elektrodenmaterial ein Polyimidharz als Bindemittel einschließt.

10. Nicht-wässrige Elektrolyt-Sekundärbatterie, verwendend das Negativ-Elektrodenmaterial nach Anspruch 8 oder Anspruch 9.

11. Nicht-wässrige Elektrolyt-Sekundärbatterie nach Anspruch 10, wobei die nicht-wässrige Elektrolyt-Sekundärbatterie eine Lithiumionen-Sekundärbatterie ist.

## Revendications

1. Procédé de fabrication d'un matériau actif d'électrode négative revêtu de carbone pour une utilisation dans une batterie secondaire à électrolyte non aqueux, dans lequel une matière première active d'électrode négative comprenant au moins l'une parmi une poudre d'oxyde de silicium et une poudre de silicium est revêtue avec du carbone par un procédé de CVD catalytique, **caractérisé en ce que** le revêtement de carbone par le procédé de CVD catalytique est effectué par la mise en contact d'un gaz comprenant une molécule organique ayant un atome de carbone avec un catalyseur chauffé par une résistance pour générer du carbone atomique et par l'exposition de la matière première active d'électrode négative au carbone atomique généré.

2. Procédé de fabrication d'un matériau actif d'électrode négative revêtu de carbone pour une utilisation dans une batterie secondaire à électrolyte non aqueux selon la revendication 1, dans lequel le catalyseur chauffé par une résistance comprend un métal tel que le ruthénium, le tantale, le tungstène, le rhénium, et l'indium, l'acier inoxydable (SUS304), les alliages tels que les alliages de chrome et de nickel, et du carbone.

3. Procédé de fabrication d'un matériau actif d'électrode négative revêtu de carbone pour une utilisation dans une batterie secondaire à électrolyte non aqueux selon la revendication 2, dans lequel le catalyseur chauffé par une résistance comprend du tungstène.

4. Procédé de fabrication d'un matériau actif d'électrode négative revêtu de carbone pour une utilisation dans une batterie secondaire à électrolyte non aqueux selon les revendications 1 à 3, dans lequel le catalyseur chauffé par une résistance est un filament catalytique.

5. Procédé de fabrication d'un matériau actif d'électrode négative revêtu de carbone pour une utilisation dans une batterie secondaire à électrolyte non-aqueux selon les revendications 1 à 4, dans lequel une poudre d'oxyde de silicium amorphe est utilisée comme poudre d'oxyde de silicium.

6. Procédé de fabrication d'un matériau actif d'électrode négative revêtu de carbone pour une utilisation dans une batterie secondaire à électrolyte non aqueux selon la revendication 1 à la revendication 5, dans lequel une poudre de silicium polycristalline ayant une taille de grain de 300 nm ou moins est utilisée comme poudre de silicium, la taille de grain étant obtenue par une méthode de Scherrer basée sur une largeur à mi-hauteur d'un raie de diffraction attribuable au Si (111) et près de 2θ = 28,4° dans une analyse du schéma de diffraction des rayons X de la poudre de silicium.

7. Procédé de fabrication d'un matériau actif d'électrode négative revêtu de carbone pour une utilisation dans une batterie secondaire à électrolyte non aqueux selon l'une quelconque des revendications 1 à 6, dans lequel le revêtement de carbone par le procédé de CVD catalytique est effectué avec la température de la matière première active d'électrode négative maintenue à moins de 1 000°C.

8. Matériau d'électrode négative pour une utilisation dans une batterie secondaire à électrolyte non aqueux, comprenant le matériau actif d'électrode négative fabriqué par le procédé de fabrication d'un matériau actif d'électrode négative pour une utilisation dans une batterie secondaire à électrolyte non aqueux selon l'une quelconque des revendications 1 à 7.

9. Matériau d'électrode négative pour une utilisation dans une batterie secondaire à électrolyte non aqueux selon la revendication 8, dans lequel le matériau d'électrode négative comprend une résine polyimide en tant que liant.

10. Batterie secondaire à électrolyte non aqueux utilisant le matériau d'électrode négative selon la revendication 8 ou la revendication 9.

11. Batterie secondaire à électrolyte non aqueux selon la revendication 10, dans laquelle la batterie secondaire à électrolyte non aqueux est une batterie secondaire au lithium.
